# EUROPEAN PATENT SPECIFICATION

(11) **EP 4 362 017 B1**
(45) Date of publication and mention of the grant of the patent: **01.04.2026**
(21) Application number: 23200671.8
(22) Date of filing: 28.09.2023
(51) Int. Cl.: G11C 7/06, G11C 7/18, G11C 11/419

(54) **MEMORY WITH FLY-BITLINES THAT WORK WITH SINGLE-ENDED SENSING AND ASSOCIATED MEMORY ACCESS METHOD**
SPEICHER MIT FLY-BITLEITUNGEN MIT EINSEITIGER ABTASTUNG UND ZUGEHÖRIGES SPEICHERZUGRIFFSVERFAHREN
MÉMOIRE AVEC LIGNES DE BIT QUI FONCTIONNE AVEC UNE DÉTECTION ASYMÉTRIQUE ET PROCÉDÉ D'ACCÈS À LA MÉMOIRE ASSOCIÉ

(30) Priority: 24.10.2022 US 202263380598 P; 21.09.2023 US 202318371441
(43) Date of publication of application: 01.05.2024
(73) Proprietor: MediaTek Inc., Hsin-Chu 300 (TW)
(72) Inventor: HONG, Chi-Hao, 30078 Hsinchu City (TW)
(74) Representative: Haseltine Lake Kempner LLP

(56) References cited:
- US-A1- 2014 085 993
- US-A1- 2019 385 671

## Description

This application claims the benefit of U.S. Provisional Application No. 63/380,598, filed on October 24th, 2022.

### Background

The present invention relates to a memory design, and more particularly, to a memory with fly-bitlines that work with single-ended sensing and an associated memory access method.

For a variety of applications, a cache storage element can be used to temporarily retain data for further processing. The traditional approach for this cache storage element is by using single-port static random access memory (SRAM) bit-cells (e.g., six-transistor (6T) single-port SRAM bit-cells) or two-port SRAM bit-cells (e.g., 8T two-port SRAM bit-cells). In a single-port SRAM bit-cell, normally, either of read operation and write operation is performed in one access through a complementary bitline pair that consists of two bitlines. When the read operation is performed on the single-port SRAM bit-cell, two bitlines of the complementary bitline pair are pre-charged to the supply voltage, a wordline is driven high after pre-charging is turned off, one of the bitlines is pulled down according to a stored value, and a differential sense amplifier is activated to capture the stored value according to a differential voltage presented at the complementary bitline pair. However, the differential sense amplifier requires complicated pre-charging timing control and pass-gate timing control. Furthermore, the differential sense amplifier has a high gate count, thus leading to large chip area as well as high power consumption. US 2019/0385671 A1 discloses an SRAM macro device with a flying BL scheme, and the memory of the SRAM macro device is split into two segments with one being disposed over the other. US 2014/0085993 A1 discloses a read tracking system and method that track multiple tracking bit cells in multiple segments and columns to incorporate device performance variation of bit cells in the memory array.

Thus, there is a need for an innovative memory design which can have small chip area, low power consumption, and/or simple timing control.

### Summary

Aspects of the present invention are defined in the accompanying claims. According to a first aspect there is provided a memory in accordance with claim 1. Accordingly to a second aspect there is provided a method in accordance with claim 8. Advantageous optional features are defined in the dependent claims. One of the objectives of the claimed invention is to provide a memory with fly-bitlines that work with single-ended sensing and an associated memory access method.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a memory design according to an embodiment of the present invention.
FIG. 2 is a diagram illustrating a single-ended sense amplifier circuit according to an embodiment of the present invention.
FIG. 3 is a diagram illustrating waveforms of a plurality of signals associated with a read operation performed by the single-ended sense amplifier circuit shown in FIG. 2.
FIG. 4 is a diagram illustrating a memory that has fly-bitlines working with single-ended sensing and does not employ an imbalanced FBL/non-FBL load according to an embodiment of the present invention.
FIG. 5 is a diagram illustrating a memory that has fly-bitlines working with single-ended sensing and employs an imbalanced FBL/non-FBL load according to an embodiment of the present invention.
FIG. 6 is a diagram illustrating another memory design according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

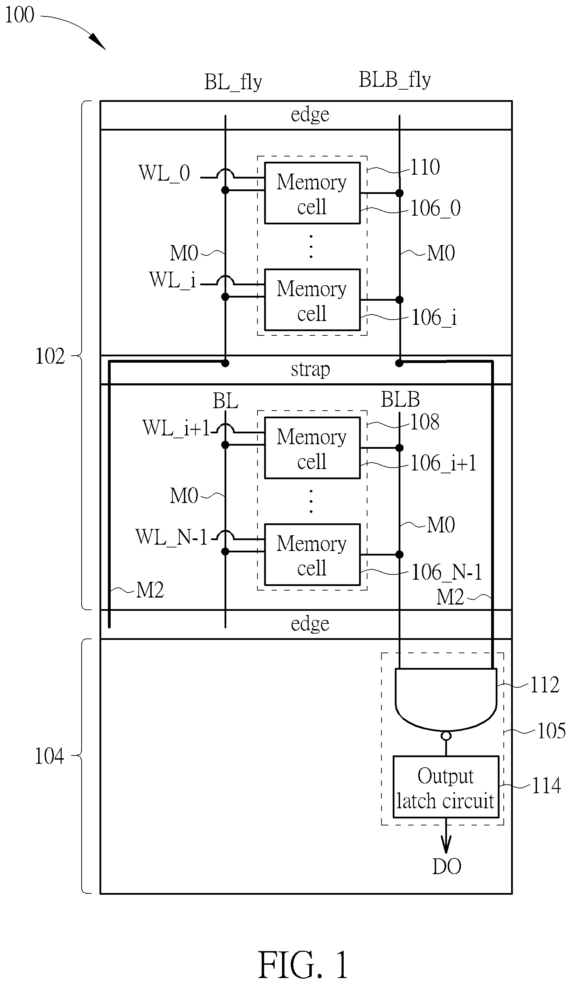

FIG. 1 is a diagram illustrating a memory design according to an embodiment of the present invention. The memory 100 includes a memory array 102 and a peripheral circuit 104. The peripheral circuit 104 acts as an input/output (I/O) circuit that is arranged to control access (read/write) of the memory array 102, and may include a row decoder circuit, a timing controller circuit, a column decoder circuit, a sense amplifier circuit, a write driver circuit, etc. Since the present invention is focused on the read operation, only the sense amplifier circuit is illustrated.

The memory array 102 includes a plurality of memory cells arranged in a two-dimensional (2D) array with a plurality of rows and a plurality of columns. As shown in FIG. 1, each memory cell column may include N memory cells 106_0-106_i and 106_i+1-106_N-1. It should be noted that the memory array 102 may include a plurality of memory cell columns. For better comprehension of technical features of the present invention, only a single memory cell column is illustrated in FIG. 1.

In this embodiment, each of the memory cells may have a single-port SRAM architecture for storing one bit, such as a 6T bit-cell architecture. As a person skilled in the pertinent art can readily understand details of the typical 6T SRAM bit-cell, further description is omitted here for brevity. The memory array 102 includes a plurality of wordlines WL_0-WL_N-1, one complementary bitline pair consisting of bitlines BL and BLB, and another complementary bitline pair consisting of bitlines BL_fly and BLB_fly, where the wordlines WL_0-WL_N-1 correspond to different memory cell rows, respectively, and the bitlines BL, BLB, BL_fly, BLB_fly correspond to the same memory cell column.

In this embodiment, a fly-bitline (FBL) structure can be adopted to improve the memory access speed. For example, each of the bitlines BL and BLB is routed on a first metal layer (e.g., M0) but not a second metal layer (e.g., M2), and each of the bitlines BL_fly and BLB_fly is an FBL that has a first segment routed on the first metal layer (e.g., M0) and a second segment routed on the second metal layer (e.g., M2), where the second segment routed on the second metal layer (e.g., M2) acts as an extension of the first segment routed on the first metal layer (e.g., M0) and is across the memory cells 106_i+1-106_N-1.

As shown in FIG. 1, the memory cells located at the same memory cell column are categorized into a first group of memory cells 108 and a second group of memory cells 110, where the first group of memory cells 108 is coupled to the bitlines BL and BLB, and the second group of memory cells 110 is coupled to the bitlines BL_fly and BLB_fly. The first group of memory cells 108 and the second group of memory cells 110 may be separated using edge regions and a strap region. Since all memory cells belonging to the same memory cell column are not needed to be coupled to the same single bitline with a long length, each of the bitlines BL, BLB, BL_fly, BLB_fly can have a shorter length, thereby improving the memory access speed.

In this embodiment, the single-ended sense amplifier circuit 105 is arranged to perform a read operation upon a target memory cell through single-ended sensing when a selected wordline is enabled. For example, the target memory cell is selected from the first group of memory cells 108 and the second group of memory cells 110 located at the same memory cell column, and the selected wordline is one of the wordlines WL_0-WL_N-1. Hence, when the selected wordline WL_j {j = 0, 1, ..., N-1} is enabled, the single-ended sense amplifier circuit 105 is activated to capture a stored data bit of the target memory cell 106_j {j = 0, 1, ..., N-1} through single-ended sensing. That is, the single-ended sense amplifier circuit 105 does not need to receive voltage levels at two bitlines BL and BLB (or BL_fly and BLB_fly) of the same complementary bitline pair to capture a stored data bit of the target memory cell. Instead, the single-ended sense amplifier circuit 105 is capable of capturing a stored data bit of the target memory cell by referring to a voltage level at one of two bitlines of a complementary bitline pair that is connected to the target memory cell.

In this embodiment, the single-ended sense amplifier circuit 105 may include a logic gate circuit (e.g., NAND gate) 112 and an output latch circuit 114. The logic gate circuit 112 is arranged to receive two single-ended input signals. For example, the logic gate circuit 112 may have a first input node coupled to one bitline BLB and a second input node coupled to another bitline BLB_fly, where the bitlines BLB and BLB_fly may be connected to SRAM cells at the same column of the memory array. For another example, the logic gate circuit 112 may have a first input node coupled to one bitline BL and a second input node coupled to another bitline BL_fly, where the bitlines BL and BL_fly may be connected to SRAM cells at the same column of the memory array. It should be noted that the logic gate circuit 112 may be implemented by a NAND gate or other logic gate, depending upon actual design considerations. The output latch circuit 114 has an input node coupled to the output node of the logic gate circuit 112, and an output node arranged to output a read-out data DO of the target memory cell.

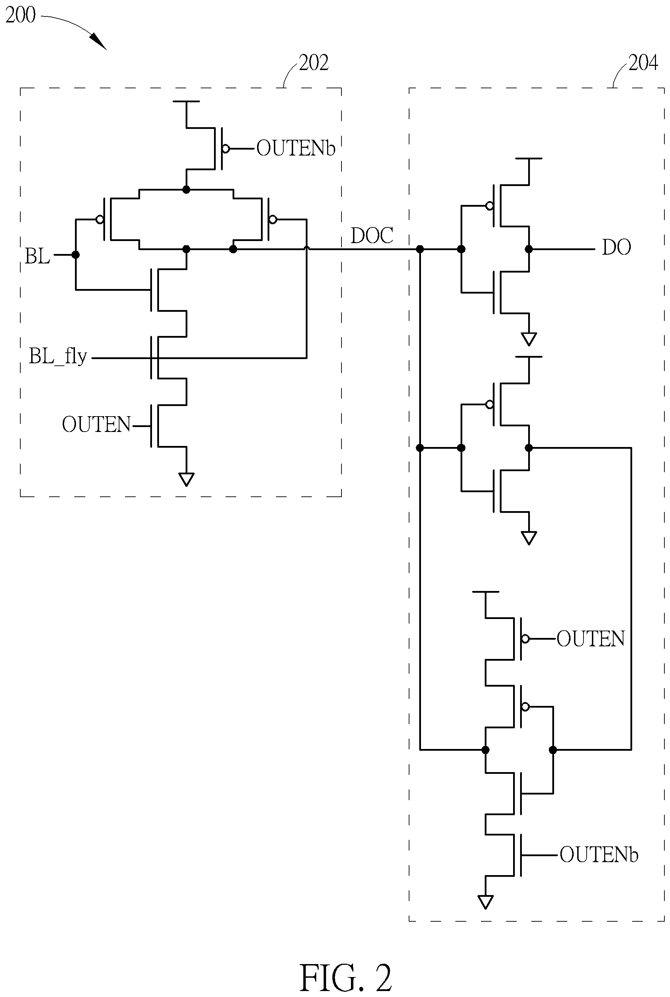

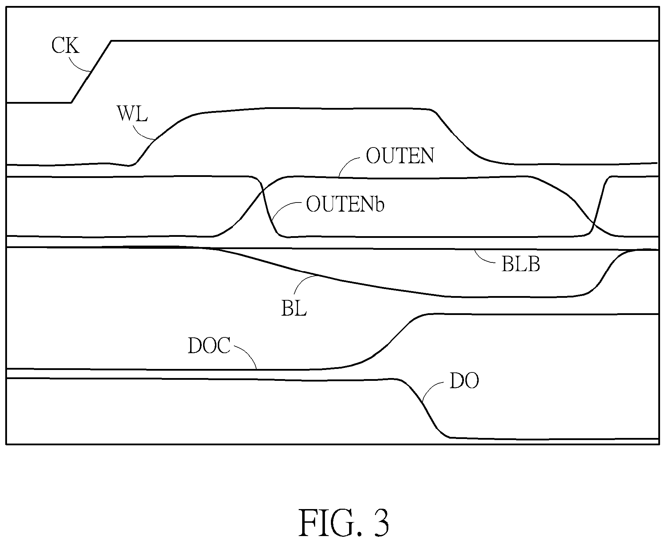

Please refer to FIG. 2 in conjunction with FIG. 3. FIG. 2 is a diagram illustrating a single-ended sense amplifier circuit according to an embodiment of the present invention. FIG. 3 is a diagram illustrating waveforms of a plurality of signals associated with a read operation performed by the single-ended sense amplifier circuit shown in FIG. 2. The single-ended sense amplifier circuit 105 used by the memory 100 shown in FIG. 1 may be implemented using the single-ended sense amplifier circuit 200 shown in FIG. 2 with two single-ended input signals obtained from bitlines BL and BL_fly.

In this embodiment, the single-ended sense amplifier circuit 200 includes a NAND gate 202 and an output latch circuit 204. One input node of the NAND gate 202 (i.e., gate terminal of one P-channel metal-oxide-semiconductor transistor) is coupled to the bitline BL, and the other input node of the NAND gate 202 (i.e., gate terminal of another P-channel metal-oxide-semiconductor transistor) is coupled to the bitline BL_fly, where the bitlines BL and BL_fly may be connected to SRAM cells at the same column of the memory array. Suppose that the selected memory cell is one of the memory cells 106_i+1-106_N-1 coupled to the complementary bitline pair consisting of bitlines BL and BLB, and stores a data bit of "0". During a read period of one cycle of the memory clock CK, pre-charging is applied to bitlines BL, BLB, BL_fly, BLB_fly (i.e., BL=VDD, BLB=VDD, BL_fly=VDD, and BLB_fly=VDD) and then turned off, a selected wordline WL of the selected memory cell is driven high by an enable pulse to allow the selected memory cell (which stores "0") to pull down the bitline BL that connected to the selected memory cell, and the single-ended sense amplifier circuit 200 is activated by a complementary control signal pair consisting of output latch signals OUTEN and OUTENb. When the bitline BL is developed and becomes lower than a trip point of the NAND gate 202, the NAND gate output signal DOC rises and then the read-out signal DO falls. It should be noted that the access time is decided by firing of the selected wordline WL and the voltage developing speed of the bitline BL if the output latch signals OUTEN and OUTENb are fired earlier than the bitline BL develops. It should be noted that, since the single-ended sense amplifier circuit 105 (or 200) is fully implemented within a global I/O circuit of the memory 100, no additional buffer(s) are needed between the logic gate circuit 112 (or NAND gate 202) and the output latch circuit 114 (or 204).

Alternatively, the single-ended sense amplifier circuit 200 may be properly modified to have two single-ended input signals obtained from bitlines BLB and BLB_fly. To put it simply, the circuit design shown in FIG. 2 is for illustrative purposes only, and is not meant to be a limitation of the present invention.

Compared to a typical differential sense amplifier circuit, the single-ended sense amplifier circuit 105/200 that works with FBL has a simple control design and a lower gate count, which leads to smaller chip area as well as lower power consumption. The single-ended sense amplifier circuit 105/200 is shown having a logic gate circuit and an output latch circuit. However, this is for illustrative purposes only, and is not meant to be a limitation of the present invention. In practice, any single-ended sensing scheme may be employed by the single-ended sense amplifier circuit 105 to works with FBL used by the memory array 102. These alternative designs all fall within the scope of the present invention.

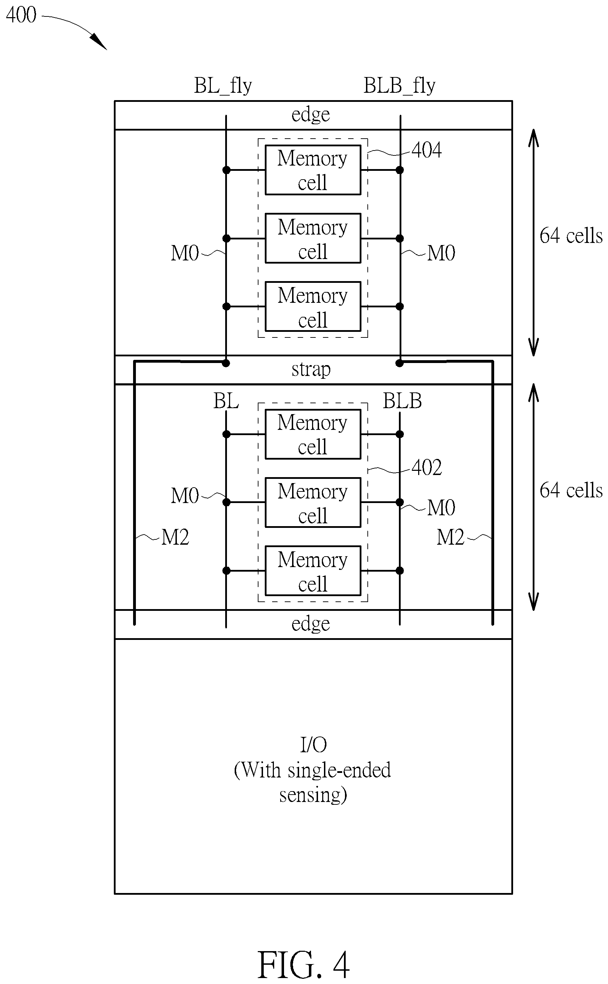

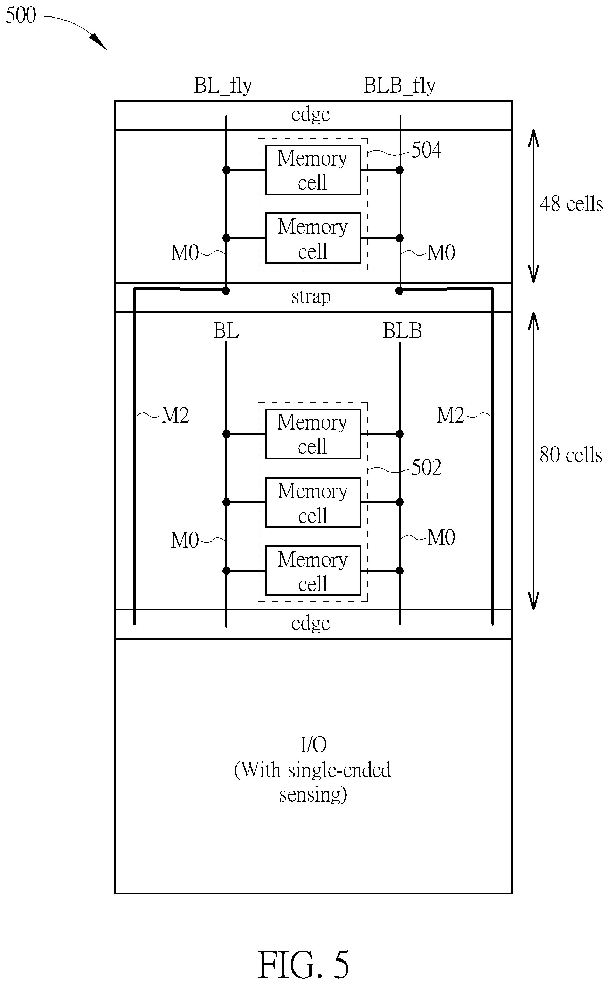

Since impedance of the bitline BL_fly/BLB_fly may not be the same as that of the bitline BL/BLB due to the fact that bitline BL_fly/BLB_fly are further routed on the second metal layer (e.g., M2), access speed of the memory cells 106_0-106_N-1 is constrained by the access speed of memory cells 106_0-106_i connected to the bitline BL_fly/BLB_fly. To address this issue, the present invention further proposes using an imbalanced FBL/non-FBL load to compensate speed. For example, a cell number of the first group of memory cells 108 (i.e., non-FBL load) may be different from a cell number of the second group of memory cells 110 (i.e., FBL load). FIG. 4 is a diagram illustrating a memory that has fly-bitlines working with single-ended sensing and does not employ an imbalanced FBL/non-FBL load according to an embodiment of the present invention, where a cell number of a first group of memory cells 402 (which are connected to bitlines BL and BLB and located at a memory cell column) is equal to a cell number of a second group of memory cells 404 (which are connected to bitlines BL_fly and BLB_fly and located at the same memory cell column). FIG. 5 is a diagram illustrating a memory that has fly-bitlines working with single-ended sensing and employs an imbalanced FBL/non-FBL load according to an embodiment of the present invention, where a cell number of a first group of memory cells 502 (which are connected to bitlines BL and BLB and located at a memory cell column) is larger than a cell number of a second group of memory cells 504 (which are connected to bitlines BL_fly and BLB_fly and located at the same memory cell column). In this way, extra load caused by the FBL routing on the second metal layer (e.g., M2) can be balanced by extra load (i.e., more memory cells) added to the non-FBL routing on the first metal layer (e.g., M0). With proper control of the imbalanced FBL/non-FBL load, access speed of memory cells connected to the bitline BL_fly/BLB_fly may be approximately the same as that of memory cells connected to the bitline BL/BLB.

In above embodiments, each of the memory cells has a single-port SRAM architecture for storing one bit, such as a 6T bit-cell architecture. However, this is for illustrative purposes only, and is not meant to be a limitation of the present invention. The same single-ended sensing concept may be applied to a memory array using two-port memory cells and fly-bitlines.

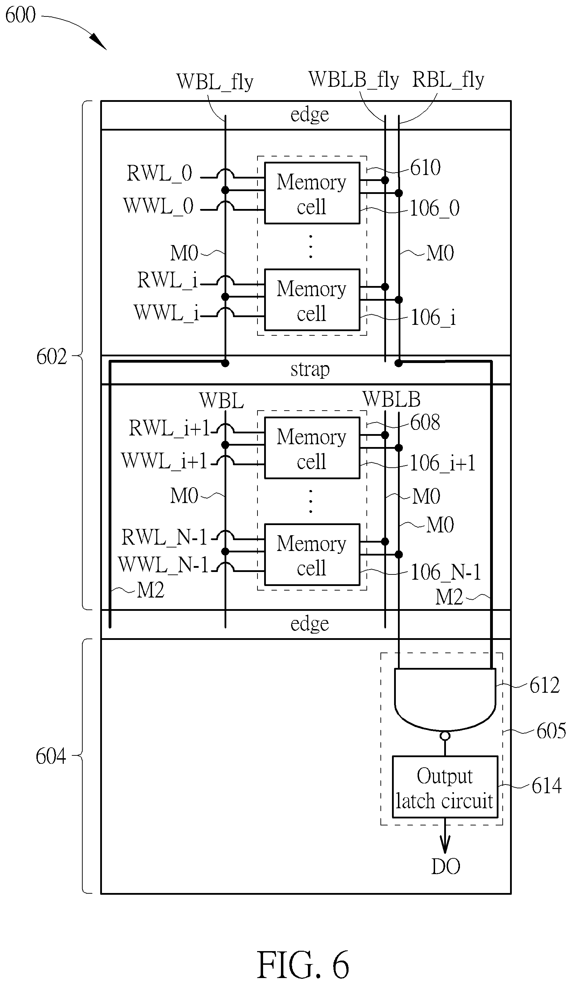

FIG. 6 is a diagram illustrating another memory design according to an embodiment of the present invention. The memory 600 includes a memory array 602 and a peripheral circuit 604. The peripheral circuit 604 may act as an I/O circuit that is arranged to control access (read/write) of the memory array 602, and may include a row decoder circuit, a timing controller circuit, a column decoder circuit, a sense amplifier circuit, a write driver circuit, etc. Since the present invention is focused on the read operation, only the sense amplifier circuit is illustrated.

The memory array 602 includes a plurality of memory cells arranged in a 2D array with a plurality of rows and a plurality of columns. As shown in FIG. 6, each memory cell column may include N memory cells 606_0-606_i and 606_i+1-606_N-1. It should be noted that the memory array 602 may include a plurality of memory cell columns. For better comprehension of technical features of the present invention, only a single memory cell column is illustrated in FIG. 6.

In this embodiment, each of the memory cells may have a two-port SRAM architecture for storing one bit, such as an 8T bit-cell architecture. As a person skilled in the pertinent art can readily understand details of the typical 8T SRAM bit-cell, further description is omitted here for brevity. The memory array 602 includes a plurality of read wordlines RWL_0-RWL_N-1 (which are used in read operations of 8T SRAM bit-cells), a plurality of write wordlines WWL_0-WWL_N-1 (which are used in write operations of 8T SRAM bit-cells), a complementary write bitline pair consisting of write bitlines WBL and WBLB (which are used in write operations of 8T SRAM bit-cells, and are not used in read operations of 8T SRAM bit-cells), a complementary write bitline pair consisting of write bitlines WBL_fly and WBLB_fly (which are used in write operations of 8T SRAM bit-cells, and are not used in read operations of 8T SRAM bit-cells), a read bitline RBL (which is used in read operations of 8T SRAM bit-cells, and is not used in write operation of 8T SRAM bit-cells), and a read bitline RBL_fly (which is used in read operations of 8T SRAM bit-cells, and is not used in write operations of 8T SRAM bit-cells), where a read wordline RWL_j and a write wordline WWL_j (j = {0, 1, ..., N-1}) correspond to a same memory cell row, and the bitlines WBL, WBLB, WBL_fly, WBLB_fly, RBL, RBL_fly correspond to a same memory cell column.

In this embodiment, an FBL structure can be adopted to improve the memory access speed. For example, each of the bitlines WBL, WBLB, and RBL is routed on a first metal layer (e.g., M0) but not a second metal layer (e.g., M2), and each of the bitlines WBL_fly, WBLB_fly, and RBL_fly is an FBL that has a first segment routed on the first metal layer (e.g., M0) and a second segment routed on a second metal layer (e.g., M2), where the second segment routed on the second metal layer (e.g., M2) acts as an extension of the first segment routed on the first metal layer (e.g., M0) and is across the memory cells 606_i+1-606_N-1.

As shown in FIG. 6, the memory cells located at the same memory cell column are categorized into a first group of memory cells 608 and a second group of memory cells 610, where the first group of memory cells 608 is coupled to the bitlines WBL, WBLB, RBL and the second group of memory cells 610 is coupled to the bitlines WBL_fly, WBLB_fly, RBL_fly. The first group of memory cells 608 and the second group of memory cells 610 may be separated by edge regions and a strap region.

In this embodiment, the single-ended sense amplifier circuit 605 is arranged to perform a read operation upon a target memory cell through single-ended sensing when a selected read wordline is enabled. For example, the target memory cell is selected from the first group of memory cells 608 and the second group of memory cells 610 located at the same memory cell column, and the selected read wordline is one of the read wordlines RWL_0-RWL_N-1.

In this embodiment, the single-ended sense amplifier circuit 605 may include a logic gate circuit (e.g., NAND gate) 612 and an output latch circuit 614. The logic gate circuit 612 is arranged to receive two single-ended input signals. For example, the logic gate circuit 612 may have a first input node coupled to one bitline RBL and a second input node coupled to another bitline RBL_fly, where the bitlines RBL and RBL_fly may be connected to SRAM cells at the same column of the memory array. It should be noted that the logic gate circuit 612 may be implemented by a NAND gate or other logic gate, depending upon actual design considerations. The output latch circuit 614 has an input node coupled to the output node of the logic gate circuit 612, and an output node arranged to output a read-out data DO of the target memory cell. Since a person skilled in the art can readily understand details of the single-ended sense amplifier circuit 605 that works with FBL after reading above paragraphs directed to the single-ended sense amplifier circuit 105/200, further description is omitted here for brevity.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A memory (100, 600) comprising:
a memory array (102, 602), comprising:
a plurality of wordlines;
a plurality of bitlines, comprising:
a first bitline, routed on a first metal layer but not a second metal layer; and
a second bitline, routed on the first metal layer and the second metal layer, wherein the second metal layer is different from the first metal layer; and
a plurality of memory cells (108, 110, 402, 404, 502, 504, 608, 610), each coupled to one of the plurality of wordlines, wherein the plurality of memory cells (108, 110, 402, 404, 502, 504, 608, 610) comprise:
a first group of memory cells (108, 402, 502, 608), coupled to the first bitline; and
a second group of memory cells (110, 404, 504, 610), coupled to the second bitline, wherein the first group of memory cells (108, 402, 502, 608) and the second group of memory cells (110, 404, 504, 610)are located at a same column; and
a single-ended sense amplifier circuit (105, 200, 605), fully implemented in a global input/output circuit of the memory (100, 600) and arranged to perform a read operation upon a target memory cell when a selected wordline is enabled, wherein each memory cell included in the first group of memory cells (108, 402, 502, 608) and the second group of memory cells (110, 404, 504, 610) is coupled to the single-ended sense amplifier circuit (105, 200, 605) through only a single bitline, and the target memory cell is selected from the first group of memory cells (110, 404, 504, 610) and the second group of memory cells (110, 404, 504, 610).

2. The memory (100, 600) of claim 1, wherein each memory (100, 600) cell included in the first group of memory cells (108, 402, 502, 608)and the second group of memory cells (110, 404, 504, 610) employs a single-port static random access memory (100, 600), SRAM, cell architecture; or
wherein each memory (100, 600) cell included in the first group of memory cells (108, 402, 502, 608) and the second group of memory cells (110, 404, 504, 610) employs a two-port static random access memory, SRAM, (100, 600) cell architecture.

3. The memory (100, 600) of claim 1, wherein the single-ended sense amplifier circuit (105, 200, 605) comprises:
a logic gate circuit (112, 612), comprising:
a first input node, coupled to the first bitline;
a second input node, coupled to the second bitline; and
an output node; and
an output latch circuit (114, 614), comprising:
an input node, coupled to the output node of the logic gate circuit (112, 612); and
an output node, arranged to output a read-out data of the target memory cell.

4. The memory (100, 600) of claim 3, wherein the first bitline is one of two bitlines of one complementary bitline pair, and the second bitline is one of two bitlines of another complementary bitline pair.

5. The memory (100, 600) of claim 3, wherein the first bitline is one read bitline, the second bitline is another read bitline, and none of the first bitline and the second bitline is used by a write operation.

6. The memory (100, 600) of claim 1, wherein a cell number of the first group of memory cells (108, 402, 502, 608) is different from a cell number of the second group of memory cells (110, 404, 504, 610).

7. The memory (100, 600) of claim 6, wherein the cell number of the first group of memory cells (108, 402, 502, 608) is larger than the cell number of the second group of memory cells (110, 404, 504, 610).

8. A method for accessing a memory array (102, 602) that comprises a plurality of wordlines, a plurality of bitlines, and a plurality of memory cells (108, 110, 402, 404, 502, 504, 608, 610), wherein the plurality of bitlines comprise a first bitline routed on a first metal layer but not a second metal layer that is different from the first metal layer, and a second bitline routed on the first metal layer and the second metal layer, each of the plurality of memory cells (108, 110, 402, 404, 502, 504, 608, 610) is coupled to one of the plurality of wordlines, the plurality of memory cells (108, 110, 402, 404, 502, 504, 608, 610) comprise a first group of memory cells (108, 402, 502, 608)coupled to the first bitline, and a second group of memory cells (110, 404, 504, 610) coupled to the second bitline, and the first group of memory cells (108, 402, 502, 608) and the second group of memory cells (110, 404, 504, 610) are located at a same column; and the method comprises:
selecting a target memory cell from the first group of memory cells (108, 402, 502, 608)and the second group of memory cells (110, 404, 504, 610); and
in response to a selected wordline being enabled, performing a read operation upon the target memory cell by a single-ended sense amplifier circuit (105, 200, 605) fully implemented in a global input/output circuit of a memory (100, 600), wherein the memory array (102, 602) is included in the memory (100, 600), and each memory cell included in the first group of memory cells (108, 402, 502, 608) and the second group of memory cells (110, 404, 504, 610) is coupled to the single-ended sense amplifier circuit (105, 200, 605) through only a single bitline.

9. The method of claim 8, wherein each memory (100, 600) cell included in the first group of memory cells (108, 402, 502, 608) and the second group of memory cells (110, 404, 504, 610) employs a single-port static random access memory, SRAM, (100, 600) cell architecture; or
wherein each memory (100, 600) cell included in the first group of memory cells (108, 402, 502, 608)and the second group of memory cells (110, 404, 504, 610) employs a two-port static random access memory, SRAM, (100, 600) cell architecture.

10. The method of claim 8, wherein performing the read operation upon the target memory cell by the single-ended sense amplifier circuit (105, 200, 605) fully implemented in the global input/output circuit of the memory (100, 600) comprises:
performing a logic operation upon a first input signal obtained from the first bitline and a second input signal obtained from the second bitline, to generate an output signal; and
performing an output latch operation upon the output signal to generate and output a read-out data of the target memory cell.

11. The method of claim 10, wherein the first bitline is one of two bitlines of one complementary bitline pair, and the second bitline is one of two bitlines of another complementary bitline pair.

12. The method of claim 10, wherein the first bitline is one read bitline, the second bitline is another read bitline, and none of the first bitline and the second bitline is used by a write operation.

13. The method of claim 8, wherein a cell number of the first group of memory cells (108, 402, 502, 608) is different from a cell number of the second group of memory cells (110, 404, 504, 610).

14. The method of claim 13, wherein the cell number of the first group of memory cells (108, 402, 502, 608)is larger than the cell number of the second group of memory cells (110, 404, 504, 610) .

## Patentansprüche

1. Speicher (100, 600), umfassend:
ein Speicherarray (102, 602), umfassend:
eine Vielzahl von Wortleitungen;
eine Vielzahl von Bitleitungen, umfassend:
eine erste Bitleitung, die auf einer ersten Metallschicht, aber nicht auf einer zweiten Metallschicht geleitet ist; und
eine zweite Bitleitung, die auf der ersten Metallschicht und der zweiten Metallschicht geleitet ist, wobei die zweite Metallschicht von der ersten Metallschicht verschieden ist; und
eine Vielzahl von Speicherzellen (108, 110, 402, 404, 502, 504, 608, 610), die jeweils mit einer der Vielzahl von Wortleitungen verbunden sind, wobei die Vielzahl von Speicherzellen (108, 110, 402, 404, 502, 504, 608, 610) Folgendes umfasst:
eine erste Gruppe von Speicherzellen (108, 402, 502, 608), die mit der ersten Bitleitung verbunden sind; und
eine zweite Gruppe von Speicherzellen (110, 404, 504, 610), die mit der zweiten Bitleitung verbunden sind, wobei sich die erste Gruppe von Speicherzellen (108, 402, 502, 608) und die zweite Gruppe von Speicherzellen (110, 404, 504, 610) in einer gleichen Spalte befinden; und
eine einseitige Abtastverstärkerschaltung (105, 200, 605), die vollständig in einer globalen Eingangs-/Ausgangsschaltung des Speichers (100, 600) implementiert und angeordnet ist, um eine Leseoperation an einer Zielspeicherzelle durchzuführen, wenn eine ausgewählte Wortleitung aktiviert ist, wobei jede Speicherzelle, die in der ersten Gruppe von Speicherzellen (108, 402, 502, 608) und in der zweiten Gruppe von Speicherzellen (110, 404, 504, 610) beinhaltet ist, über nur eine einzige Bitleitung mit der einseitigen Abtastverstärkerschaltung (105, 200, 605) verbunden ist und die Zielspeicherzelle aus der ersten Gruppe von Speicherzellen (110, 404, 504, 610) und der zweiten Gruppe von Speicherzellen (110, 404, 504, 610) ausgewählt ist.

2. Speicher (100, 600) nach Anspruch 1, wobei jede Speicher(100, 600)-Zelle, die in der ersten Gruppe von Speicherzellen (108, 402, 502, 608) und der zweiten Gruppe von Speicherzellen (110, 404, 504, 610) beinhaltet ist, eine Zellarchitektur eines statischen Direktzugriffsspeichers (100, 600) (static random access memory, SRAM) mit einem einzigen Anschluss einsetzt; oder
wobei jede Speicher(100, 600)-Zelle, die in der ersten Gruppe von Speicherzellen (108, 402, 502, 608) und der zweiten Gruppe von Speicherzellen (110, 404, 504, 610) beinhaltet ist, eine Zellarchitektur eines statischen Direktzugriffsspeichers (100, 600) (SRAM) mit zwei Anschlüssen einsetzt.

3. Speicher (100, 600) nach Anspruch 1, wobei die einseitige Abtastverstärkerschaltung (105, 200, 605) Folgendes umfasst:
eine Logikgatterschaltung (112, 612), umfassend:
einen ersten Eingangsknoten, der mit der ersten Bitleitung verbunden ist;
einen zweiten Eingangsknoten, der mit der zweiten Bitleitung verbunden ist; und
einen Ausgangsknoten; und
eine Ausgangsverriegelungsschaltung (114, 614), umfassend:
einen Eingangsknoten, der mit dem Ausgangsknoten der Logikgatterschaltung (112, 612) verbunden ist; und
einen Ausgangsknoten, der angeordnet ist, um Auslesedaten der Zielspeicherzelle auszugeben.

4. Speicher (100, 600) nach Anspruch 3, wobei die erste Bitleitung eine von zwei Bitleitungen eines komplementären Bitleitungspaares ist und die zweite Bitleitung eine von zwei Bitleitungen eines weiteren komplementären Bitleitungspaares ist.

5. Speicher (100, 600) nach Anspruch 3, wobei die erste Bitleitung eine Lesebitleitung ist, die zweite Bitleitung eine weitere Lesebitleitung ist und keine der ersten Bitleitung und der zweiten Bitleitung von einer Schreiboperation verwendet wird.

6. Speicher (100, 600) nach Anspruch 1, wobei eine Zellzahl der ersten Gruppe von Speicherzellen (108, 402, 502, 608) von einer Zellzahl der zweiten Gruppe von Speicherzellen (110, 404, 504, 610) verschieden ist.

7. Speicher (100, 600) nach Anspruch 6, wobei die Zellzahl der ersten Gruppe von Speicherzellen (108, 402, 502, 608) größer als die Zellzahl der zweiten Gruppe von Speicherzellen (110, 404, 504, 610) ist.

8. Verfahren zum Zugreifen auf ein Speicherarray (102, 602), das eine Vielzahl von Wortleitungen, eine Vielzahl von Bitleitungen und eine Vielzahl von Speicherzellen (108, 110, 402, 404, 502, 504, 608, 610) umfasst, wobei die Vielzahl von Bitleitungen eine erste Bitleitung, die auf einer ersten Metallschicht, aber nicht auf einer zweiten Metallschicht, die von der ersten Metallschicht verschieden ist, geleitet ist, und eine zweite Bitleitung, die auf der ersten Metallschicht und der zweiten Metallschicht geleitet ist, umfasst, wobei jede der Vielzahl von Speicherzellen (108, 110, 402, 404, 502, 504, 608, 610) mit einer der Vielzahl von Wortleitungen verbunden ist, die Vielzahl von Speicherzellen (108, 110, 402, 404, 502, 504, 608, 610) eine erste Gruppe von Speicherzellen (108, 402, 502, 608), die mit der ersten Bitleitung verbunden sind, und eine zweite Gruppe von Speicherzellen (110, 404, 504, 610), die mit der zweiten Bitleitung verbunden sind, umfasst und sich die erste Gruppe von Speicherzellen (108, 402, 502, 608) und die zweite Gruppe von Speicherzellen (110, 404, 504, 610) in einer gleichen Spalte befinden; und das Verfahren Folgendes umfasst:
Auswählen einer Zielspeicherzelle aus der ersten Gruppe von Speicherzellen (108, 402, 502, 608) und der zweiten Gruppe von Speicherzellen (110, 404, 504, 610); und
als Reaktion darauf, dass eine ausgewählte Wortleitung aktiviert wird, Durchführen einer Leseoperation an der Zielspeicherzelle durch eine einseitige Abtastverstärkerschaltung (105, 200, 605), die vollständig in einer globalen Eingangs-/Ausgangsschaltung eines Speichers (100, 600) implementiert ist, wobei das Speicherarray (102, 602) in dem Speicher (100, 600) beinhaltet ist und jede Speicherzelle, die in der ersten Gruppe von Speicherzellen (108, 402, 502, 608) und der zweiten Gruppe von Speicherzellen (110, 404, 504, 610) beinhaltet ist, über nur eine einzige Bitleitung mit der einseitigen Abtastverstärkerschaltung (105, 200, 605) verbunden ist.

9. Verfahren nach Anspruch 8, wobei jede Speicher(100, 600)-Zelle, die in der ersten Gruppe von Speicherzellen (108, 402, 502, 608) und der zweiten Gruppe von Speicherzellen (110, 404, 504, 610) beinhaltet ist, eine Zellarchitektur eines statischen Direktzugriffsspeichers (SRAM) (100, 600) mit einem einzigen Anschluss einsetzt; oder
wobei jede Speicher(100, 600)-Zelle, die in der ersten Gruppe von Speicherzellen (108, 402, 502, 608) und der zweiten Gruppe von Speicherzellen (110, 404, 504, 610) beinhaltet ist, eine Zellarchitektur eines statischen Direktzugriffsspeichers (100, 600) (SRAM) mit zwei Anschlüssen einsetzt.

10. Verfahren nach Anspruch 8, wobei ein Durchführen der Leseoperation an der Zielspeicherzelle durch die vollständig in der globalen Eingangs-/Ausgangsschaltung des Speichers (100, 600) implementierte einseitige Abtastverstärkerschaltung (105, 200, 605) Folgendes umfasst:
Durchführen einer logischen Operation an einem von der ersten Bitleitung erhaltenen ersten Eingangssignal und einem von der zweiten Bitleitung erhaltenen zweiten Eingangssignal, um ein Ausgangssignal zu erzeugen; und
Durchführen einer Ausgangsverriegelungsoperation an dem Ausgangssignal, um Auslesedaten der Zielspeicherzelle zu erzeugen und auszugeben.

11. Verfahren nach Anspruch 10, wobei die erste Bitleitung eine von zwei Bitleitungen eines komplementären Bitleitungspaares ist und die zweite Bitleitung eine von zwei Bitleitungen eines weiteren komplementären Bitleitungspaares ist.

12. Verfahren nach Anspruch 10, wobei die erste Bitleitung eine Lesebitleitung ist, die zweite Bitleitung eine weitere Lesebitleitung ist und keine der ersten Bitleitung und der zweiten Bitleitung von einer Schreiboperation verwendet wird.

13. Verfahren nach Anspruch 8, wobei eine Zellzahl der ersten Gruppe von Speicherzellen (108, 402, 502, 608) von einer Zellzahl der zweiten Gruppe von Speicherzellen (110, 404, 504, 610) verschieden ist.

14. Verfahren nach Anspruch 13, wobei die Zellzahl der ersten Gruppe von Speicherzellen (108, 402, 502, 608) größer als die Zellzahl der zweiten Gruppe von Speicherzellen (110, 404, 504, 610) ist.

## Revendications

1. Mémoire (100, 600) comprenant :
un tableau de mémoire (102, 602), comprenant :
une pluralité de lignes de mots ;
une pluralité de lignes de bits, comprenant :
une première ligne de bits, routée sur une première couche métallique mais pas sur une seconde couche métallique ; et
une seconde ligne de bits, routée sur la première couche métallique et la seconde couche métallique, dans laquelle la seconde couche métallique est différente de la première couche métallique ; et
une pluralité de cellules de mémoire (108, 110, 402, 404, 502, 504, 608, 610), chacune couplée à l'une de la pluralité de lignes de mots, dans laquelle la pluralité de cellules de mémoire (108, 110, 402, 404, 502, 504, 608, 610) comprend :
un premier groupe de cellules de mémoire (108, 402, 502, 608), couplé à la première ligne de bits ; et
un second groupe de cellules de mémoire (110, 404, 504, 610), couplé à la seconde ligne de bits, dans laquelle le premier groupe de cellules de mémoire (108, 402, 502, 608) et le second groupe de cellules de mémoire (110, 404, 504, 610) sont situés sur une même colonne ; et
un circuit amplificateur de détection à extrémité unique (105, 200, 605), entièrement mis en œuvre dans un circuit d'entrée/sortie global de la mémoire (100, 600) et configuré pour réaliser une opération de lecture sur une cellule de mémoire cible lorsqu'une ligne de mots sélectionnée est activée, dans laquelle chaque cellule de mémoire incluse dans le premier groupe de cellules de mémoire (108, 402, 502, 608) et le second groupe de cellules de mémoire (110, 404, 504, 610) est couplée au circuit amplificateur de détection à extrémité unique (105, 200, 605) par une seule ligne de bits, et la cellule de mémoire cible est sélectionnée parmi le premier groupe de cellules de mémoire (110, 404, 504, 610) et le second groupe de cellules de mémoire (110, 404, 504, 610).

2. Mémoire (100, 600) selon la revendication 1, dans laquelle chaque cellule de mémoire (100, 600) incluse dans le premier groupe de cellules de mémoire (108, 402, 502, 608) et le second groupe de cellules de mémoire (110, 404, 504, 610) utilise une architecture de cellule de mémoire vive statique à accès aléatoire à port unique (100, 600), SRAM ; ou
dans laquelle chaque cellule de mémoire (100, 600) incluse dans le premier groupe de cellules de mémoire (108, 402, 502, 608) et le second groupe de cellules de mémoire (110, 404, 504, 610) utilise une architecture de cellule de mémoire vive statique à accès aléatoire à double port (100, 600), SRAM.

3. Mémoire (100, 600) selon la revendication 1, dans laquelle le circuit amplificateur de détection à entrée unique (105, 200, 605) comprend :
un circuit de porte logique (112, 612), comprenant :
un premier nœud d'entrée, couplé à la première ligne de bits ;
un second nœud d'entrée, couplé à la seconde ligne de bits ; et
un nœud de sortie ; et
un circuit de verrouillage de sortie (114, 614), comprenant :
un nœud d'entrée, couplé au nœud de sortie du circuit de porte logique (112, 612) ; et
un nœud de sortie, configuré pour fournir des données de lecture de la cellule mémoire cible.

4. Mémoire (100, 600) selon la revendication 3, dans laquelle la première ligne de bits est l'une de deux lignes de bits d'une paire de lignes de bits complémentaires, et la seconde ligne de bits est l'une de deux lignes de bits d'une autre paire de lignes de bits complémentaires.

5. Mémoire (100, 600) selon la revendication 3, dans laquelle la première ligne de bits est une ligne de bits de lecture, la seconde ligne de bits est une autre ligne de bits de lecture, et aucune de la première ligne de bits et de la seconde ligne de bits n'est utilisée par une opération d'écriture.

6. Mémoire (100, 600) selon la revendication 1, dans laquelle un nombre de cellule du premier groupe de cellules de mémoire (108, 402, 502, 608) est différent d'un nombre de cellule du second groupe de cellules de mémoire (110, 404, 504, 610).

7. Mémoire (100, 600) selon la revendication 6, dans laquelle le nombre de cellule du premier groupe de cellules de mémoire (108, 402, 502, 608) est supérieur au nombre de cellule du second groupe de cellules de mémoire (110, 404, 504, 610).

8. Procédé d'accès à un tableau de mémoire (102, 602) qui comprend une pluralité de lignes de mots, une pluralité de lignes de bits et une pluralité de cellules de mémoire (108, 110, 402, 404, 502, 504, 608, 610), dans lequel la pluralité de lignes de bits comprend une première ligne de bits routée sur une première couche métallique, mais pas sur une seconde couche métallique qui est différente de la première couche métallique, et une seconde ligne de bits routée sur la première couche métallique et la seconde couche métallique, chacune de la pluralité de cellules mémoire (108, 110, 402, 404, 502, 504, 608, 610) est couplée à l'une de la pluralité de lignes de mots, la pluralité de cellules de mémoire (108, 110, 402, 404, 502, 504, 608, 610) comprend un premier groupe de cellules de mémoire (108, 402, 502, 608) couplé à la première ligne de bits, et un second groupe de cellules de mémoire (110, 404, 504, 610) couplé à la seconde ligne de bits, et le premier groupe de cellules de mémoire (108, 402, 502, 608) et le second groupe de cellules de mémoire (110, 404, 504, 610) sont situés sur la même colonne ; et le procédé comprend :
la sélection d'une cellule de mémoire cible parmi le premier groupe de cellules de mémoire (108, 402, 502, 608) et le second groupe de cellules de mémoire (110, 404, 504, 610) ; et
en réponse à l'activation de la ligne de mots sélectionnée, la réalisation d'une opération de lecture sur la cellule de mémoire cible par un circuit amplificateur de détection à extrémité unique (105, 200, 605), entièrement mis en œuvre dans un circuit d'entrée/sortie global d'une mémoire (100, 600), dans lequel le tableau de mémoire (102, 602) est inclus dans la mémoire (100, 600) et chaque cellule de mémoire incluse dans le premier groupe de cellules de mémoire (108, 402, 502, 608) et le second groupe de cellules de mémoire (110, 404, 504, 610) est couplée au circuit amplificateur de détection à extrémité unique (105, 200, 605) par une seule ligne de bits.

9. Procédé selon la revendication 8, dans lequel chaque cellule de mémoire (100, 600) incluse dans le premier groupe de cellules de mémoire (108, 402, 502, 608) et le second groupe de cellules de mémoire (110, 404, 504, 610) utilise une architecture de cellule de mémoire vive statique à accès aléatoire à port unique (100, 600), SRAM ; ou
dans lequel chaque cellule de mémoire (100, 600) incluse dans le premier groupe de cellules de mémoire (108, 402, 502, 608) et le second groupe de cellules de mémoire (110, 404, 504, 610) utilise une architecture de cellule de mémoire vive statique à accès aléatoire à double port (100, 600), SRAM.

10. Procédé selon la revendication 8, dans lequel la réalisation de l'opération de lecture sur la cellule de mémoire cible par le circuit amplificateur de détection à extrémité unique (105, 200, 605) entièrement mis en œuvre dans le circuit d'entrée/sortie global de la mémoire (100, 600) comprend :
la réalisation d'une opération logique sur un premier signal d'entrée obtenu à partir de la première ligne de bits et un second signal d'entrée obtenu à partir de la seconde ligne de bits, afin de générer un signal de sortie ; et
la réalisation d'une opération de verrouillage de sortie sur le signal de sortie pour générer et produire des données de lecture de la cellule de mémoire cible.

11. Procédé selon la revendication 10, dans lequel la première ligne de bits est l'une de deux lignes de bits d'une paire de lignes de bits complémentaires, et la seconde ligne de bits est l'une de deux lignes de bits d'une autre paire de lignes de bits complémentaires.

12. Procédé selon la revendication 10, dans lequel la première ligne de bits est une ligne de bits de lecture, la seconde ligne de bits est une autre ligne de bits de lecture, et aucune de la première ligne de bits et de la seconde ligne de bits n'est utilisée par une opération d'écriture.

13. Procédé selon la revendication 8, dans lequel un nombre de cellule du premier groupe de cellules de mémoire (108, 402, 502, 608) est différent d'un nombre de cellule du second groupe de cellules de mémoire (110, 404, 504, 610).

14. Procédé selon la revendication 13, dans lequel le nombre de cellule du premier groupe de cellules de mémoire (108, 402, 502, 608) est supérieur au nombre de cellule du second groupe de cellules de mémoire (110, 404, 504, 610).
